# EUROPEAN PATENT SPECIFICATION

(11) **EP 1 364 464 B1**
(45) Date of publication and mention of the grant of the patent: **06.04.2016**
(21) Application number: 01979670.5
(22) Date of filing: 09.10.2001
(51) Int. Cl.: H04B 1/00

(54) **ADJUSTMENT OF BIAS CURRENT IN A FIRST INTEGRATED CIRCUIT BASED ON A SIGNAL GAIN OF A SECOND INTEGRATED CIRCUIT**
EINSTELLUNG DES VORSPANNUNGSSTROMS IN EINER ERSTEN INTEGRIERTEN SCHALTUNG, IN BEZUG AUF DER SIGNALVERSTÄRKUNG EINER ZWEITEN INTEGRIERTEN SCHALTUNG
REGLAGE DU COURANT DE POLARISATION DANS UN PREMIER CIRCUIT INTEGRE SUR LA BASE D'UN GAIN DE SIGNAL D'UN SECOND CIRCUIT INTEGRE

(30) Priority: 10.10.2000 US 686266
(43) Date of publication of application: 26.11.2003
(73) Proprietor: QUALCOMM INCORPORATED, San Diego, CA 92121-1714 (US)
(72) Inventor: WALKER, Brett, C., San Diego, CA 92131 (US); ZEISEL, Eric, San Diego, CA 92109 (US)
(74) Representative: O'Neill, Aoife
(86) International application number: PCT/US2001/031694
(87) International publication number: WO 2002/031996

(56) References cited:
- EP-A- 1 033 808
- WO-A-00/39935
- DE-A- 19 718 109
- US-A- 4 510 460
- US-A- 5 559 471

## Description

### BACKGROUND OF THE INVENTION

### I. Field of the Invention

The present invention relates to communications circuits. More particularly, the present invention relates to novel and improved techniques for adjusting the bias currents of circuits in a first integrated circuit (IC) based on a signal gain of a second IC.

### II. Description of the Related Art

The design of a high performance transmitter is made challenging by various design considerations. First, high performance is required for many applications. High performance can be defined by the linearity of the active devices (e.g., amplifiers, mixers, etc.) and their noise performance. Second, for some applications such as cellular communications systems, low power consumption is an important design goal because of the portable nature of the cell phones or remote stations. Generally, high performance and low power consumption impose conflicting design constraints.

In addition to the above design goals, some transmitters are required to provide a wide range of adjustment in their transmit output power. One application that requires this wide power adjustment is a Code Division Multiple Access (CDMA) communications system. In the CDMA system, the signal from each user is spectrally spread over the entire (e.g., 1.2288 MHz) system bandwidth. Thus, the transmitted signal from each transmitting user acts as interference to those of other users in the system. To increase system capacity, the output power of each transmitting remote station is adjusted such that a required level of performance (e.g., a particular bit error rate) is maintained while minimizing interference to other users.

The transmitted signal from the remote station is affected by various transmission phenomenons, including path loss and fading. These phenomenons, in combination with the need to control the transmit power, can impose a difficult specification on the required transmit power control range. In fact, for the CDMA system, each remote station transmitter is required to be able to adjust its output power over a range of approximately 85 dB.

The linearity of the remote station transmitter is also specified for the CDMA system (i.e., indirectly by an adjacent channel power rejection ACPR specification). For most active circuits, linearity is determined, in part, by the amount of current used to bias the circuits. Greater linearity can generally be achieved by using greater amounts of bias current. Also, greater range of linearity is needed for larger signal levels, which again can be achieved by using greater amounts of bias current.

To achieve the required level of linearity at all (including high) output power levels, the active circuits in the transmit signal path can be biased with large amounts of current. For example, the active circuits can be biased with the amount of bias current that provides the required level of linearity at the maximum specified output power level. This would ensure that the required level of linearity is provided at all transmit power levels. However, this scheme consumes large amounts of bias current at all times, even during transmissions at lower output power levels, thus resulting in wasteful consumption of power.

To further complicate the matter, the transmit signal path may be implemented using two or more integrated circuits (ICs). For example, an IF portion of the transmit signal path may be implemented on one IC and a RF portion may be implemented on another IC. An effect ve and efficient bias control mechanism would need to integrate the gain and bias controls of both portions to provide the required performance while conserving power.

US Patent No 5,559,471 relates to an an amplifier included in a transmitter comprising :
- a voltage controlled attenuator controlled by a control signal according to the RF output power feedback
- and two active circuits biased by two corresponding bias supply signals , wherein the two biasing voltages are respectively VOUT1= Vt*(1+(R1/R2))+Vcontrol and VOUT2=Vt*(1+(R1+R3)/R2)+Vcontrol, Vt being the gate threshold voltage.

### SUMMARY OF THE INVENTION

The present invention relates to a method of controlling a bias current of an active circuit in a transmit signal path and to a transmitter, as defined in the appended claims.

The present invention provides techniques to adjust the bias currents of active circuits implemented on one integrated circuit (IC) based on signal gain(s) of variable gain element(s) implemented on another IC. Generally, the bias current for a particular active circuit affects various performances including linearity, noise figure, frequency response, and others. The amount of bias current that provides the required level of performance is dependent on the input signal or power level provided to the active circuit. The power level can be inferred from the gain control signal (s) used to control the variable gain elements located prior to the active circuit in the transmit signal path.

An embodiment of the invention provides a method for controlling a bias current of an active circuit in a transmit signal path. In accordance with the method, at least one gain control signal is received, with each gain control signal being indicative of a signal gain of a variable gain element located prior to the active circuit in the transmit signal path. A signal (or power) level of an input signal provided to the active circuit is then estimated, with the estimated input signal level being based, in part, on the received at least one gain control signal. A bias current for the active circuit is determined based, in part, on the estimated input signal level. The active circuit is biased with the determined bias current.

The method is particularly advantageous when the input signal is provided from one IC and the active circuit is implemented on another IC. The input signal can be provided from an IF portion of the transmit signal path and the active circuit can be a part of a RF portion. The biased current can be limited to a range defined by an upper bias current and a lower bias current (which can be set, for example, at 10 to 50 percents of the upper bias current). The active circuit can be, for example, a mixer, a buffer, an amplifier, or other types of active circuits.

Another embodiment of the invention provides a transmitter that includes at least one variable gain element, at least one active circuit, a gain control circuit, and a bias control circuit. The variable gain element(s) are implemented on a first IC and the active circuit(s) are implemented on a second IC, with the output of the first IC operatively coupled to an input of the second IC. The gain control circuit couples to the variable gain element(s) and provides a gain control signal for each variable gain element. The bias control circuit(s) couples to the gain control circuit and to a select one or more of the active circuit(s), and provides a bias signal for each selected active circuit. The bias signal is generated in accordance with the gain control signal(s) from the gain control circuit. Each variable gain element can be implemented as a variable gain amplifier (VGA), an attenuator, a multiplier, or other circuits. The bias control circuit can be implemented with a pair of "current steering differential pair" and a pair of (programmable) current sources, one current source for each current steering differential pair. A bandgap reference circuit can be used to provide a reference current that is stable over temperature and power supply variations.

### BRIEF DESCRIPTION OF THE DRAWINGS

The features, nature, and advantages of the present invention will become more apparent from the detailed description set forth below when taken in conjunction with the drawings in which like reference characters identify correspondingly throughout and wherein:
FIG. 1 shows a simplified block diagram of an embodiment of a transmitter;
FIG. 2 shows a simplified block diagram of a specific implementation of a transmitter;
FIG. 3 shows a diagram of a CDMA spread spectrum signal and distortion components generated by non-linearity in the transmit signal path;
FIG. 4 shows a plot of the signal swing of a circuit in the transmit signal path for a particular bias current setting;
FIG. 5 shows plots of the bias current I_{bias} and the signal current I_{signal} for a particular active circuit in the transmit signal path versus input power level Pᵢₙ into the circuit;
FIG. 6 shows a plot of the IF output power level versus IF gain control;
FIG. 7 shows plots of the minimum bias current I_{bias,min} and the nominal bias current I_{bias,nom} for a circuit in the transmit signal path versus gain control values; and
FIG. 8 shows a schematic diagram of an embodiment of a bias control circuit used to generate a bias current I_{bias} having a transfer function resembling the hyperbolic function shown in FIG. 7.

### DETAILED DESCRIPTION OF THE SPECIFIC EMBODIMENTS

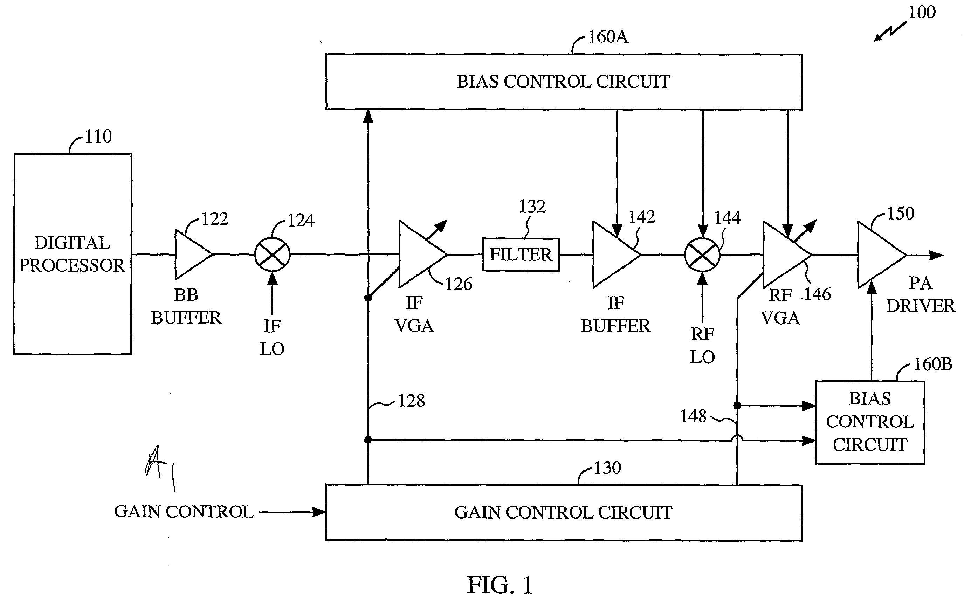

FIG. 1 shows a simplified block diagram of an embodiment of a transmitter 100. A digital processor 110 generates data, encodes and modulates the data, and converts the digitally processed data into an analog signal. The analog signal is provided to a baseband (BB) buffer 122 that buffers the signal and provides the buffered signal to a mixer 124. Mixer 124 also receives a carrier signal (e.g., a sinusoid) at an intermediate frequency (IF LO) and upconverts or modulates the buffered baseband signal with the IF LO to generate an IF signal. The IF signal is provided to an IF variable gain amplifier (IF VGA) 126 that amplifies the signal with a gain determined by a gain control signal 128 from a gain control circuit 130. The amplified IF signal is provided to a filter 132 that filters the IF signal to remove out-of-band noise and undesired signals. Filter 132 is typically a bandpass filter.

The filtered IF signal is provided to an IF buffer 142 that buffers the signal and provides the buffered IF signal to a mixer 144. Mixer 144 also receives another carrier signal (e.g., a sinusoid) at a radio frequency (RF LO) and upconverts the buffered IF signal with the RF LO to generate a RF signal. Mixer 124 and 144 can each be a single sideband mixer or a double sideband mixer. For a single sideband mixer, one or more phase shifters may be used to generate carrier signals having the proper phases. The RF signal is provided to a RF VGA 146 that amplifies the signal with a gain determined by a gain control signal 148 from gain control circuit 130. The amplified RF signal is provided to a power amplifier (PA) driver 150 that interfaces with subsequent circuitry such as an external filter (i.e., for filtering of image and spurious signals) and a power amplifier (both elements not shown in FIG. 1). The PA provides the required signal drive, and its output couples to an antenna via an isolator and a duplexer (not shown in FIG. 1).

The transmit signal path shown in FIG.1 includes an IF signal path and a RF signal path (or an IF and a RF portion). The IF signal path can include BB buffer 122, mixer 124, IF VGA 126, and possibly filter 132. The RF signal path can include IF buffer 142, mixer 144, RF VGA 146, and PA driver 150. Generally, the IF signal path includes circuit elements that receive the analog (baseband) signal (e.g., from the digital processor) and generate a processed (e.g., upconvertered and/or modulated) IF signal. The RF signal path includes circuit elements that receive the processed IF signal and generate the output RF signal.

Various modifications can be made to the transmitter embodiment shown in FIG. 1. For example, fewer or additional filter, buffer, and amplifier stages can be provided in the transmit signal path. Moreover, the elements within the signal path can be arranged in different configurations. In addition, the variable gain in the transmit signal path can be provided by VGAs (as shown in FIG. 1), variable attenuators, multipliers, other variable gain elements, or a combination of the above. In a specific implementation, the IF signal path from BB buffer 122 to IF VGA 126 is implemented within one integrated circuit and the RF signal path from IF buffer 142 to PA driver 150 is implemented within a second integrated circuit, although a different number of integrated circuits can be used.

In one specific transmitter embodiment, quadrature modulation is performed on an inphase (I) baseband signal and a quadrature (Q) baseband signal from the digital processor. In this design, a pair of BB buffers buffer the I and Q baseband signals and a pair of mixers modulate the buffered I and Q baseband signals with the inphase and quadrature IF LOs, respectively. The I and Q modulated signals are then combined to generate the IF signal. In another specific transmitter embodiment, quadrature modulation is performed digitally within the digital processor, and the modulated signal is then upconverted to IF or RF using one or more frequency upconversion stages.

Transmitter 100 can be used in many communication applications, such as cellular communication systems. Examples of cellular communication systems include Code Division Multiple Access (CDMA) communications systems, Time Division Multiple Access (TDMA) communications systems, and analog FM communications systems. CDMA systems are typically designed to conform to the "TIA/EIA/IS-95-A Mobile Station-Base Station Compatibility Standard for Dual-Mode Wideband Spread Spectrum Cellular System," hereinafter referred to as the IS-95-A standard. CDMA systems may also be designed to conform to the TIA/EIA/IS-98-A, -B, and -C standards entitled "Recommended Minimum Performance Standard for Dual-Mode Spread Spectrum Cellular and PCS Mobile Stations," hereinafter collectively referred to as the IS-98 standard.

The IS-95-A standard requires the output power from a remote station to be adjustable over a range of 85 dB in specified (e.g., 0.5 dB) increments. Typical remote stations are designed to transmit from between approximately - 50 dBm to +23 dBm. Typically, the circuits in the transmit signal path amplify or attenuate the signal so that a proper signal level is provided to the PA that interfaces with the antenna. In some transmitter embodiments, the output PA is designed with a fixed gain but variable drive capability. The variable drive can be provided by a PA design having multiple (i.e., parallel) drivers that can be selectively turned off when not required.

For some transmitter embodiments, and particularly for transmitter embodiments having fixed gain PAs, the required power control adjustment is provided by the VGAs in the transmit signal path. One VGA is typically not able to provide the entire (e.g., 85 dB) of gain adjustment and multiple cascaded VGAs are often used. The total required gain control range can be: 1) split between the IF VGA and the RF VGA, 2) provided entirely by the IF VGA, or 3) provided entirely by the RF VGA.

In some transmitter embodiments, one VGA is designed with fine gain adjustment (e.g., in increments of 0.5 dB) and the remaining VGA(s) are designed with coarse gain adjustment (e.g., in increments of several dBs or more). The coarse gain adjustment VGA can have two or more gain settings (e.g., low, intermediate, and high gains), with each gain setting corresponding to a particular range of transmitter output power levels. In some other transmitter embodiments, the VGAs can be designed to have variable (i.e., continuous) gain adjustment. The gains of the VGAs are typically controlled in a manner to provide high performance (i.e., improved linearity and reduced noise). Each VGA is typically controlled by its own gain control signal, although it is possible to control multiple VGAs with a common gain control signal.

The VGAs are designed to provide the required gain adjustment. The VGAs and other active circuits in the transmit signal path are also designed to provide the required level of linearity. The linearity of most active circuits is determined, in part, by the amount of current used to bias the circuits. Greater linearity can generally be achieved by using greater amounts of bias current. Also, greater range of linearity is also needed for larger signal levels, which again can be achieved by using greater amounts of bias current.

The transmit signal path is typically designed to provide the required level of performance (i.e., linearity) at the worst case (i.e., maximum) output power level. The required level of performance can be achieved by biasing the circuits in the transmit signal path with high bias current. However, for some transmitters such as those in CDMA remote stations, the maximum transmission condition occurs only some of the time. Thus, in accordance with the invention, the bias currents of the circuits in the transmit signal path are reduced when not required (i.e., when transmitting at less than the maximum output power level).

As shown in FIG. 1, a bias control circuit 160a receives gain control signal 128 and can adjust the bias currents of IF buffer 142, mixer 144, and RF VGA 146 based on the received gain control signal. Similarly, a bias control circuit 160b receives gain control signals 128 and 148 and can adjust the bias current of PA driver 150 based on the received gain control signals. The adjustment of the bias currents based on the gain control signals is described below.

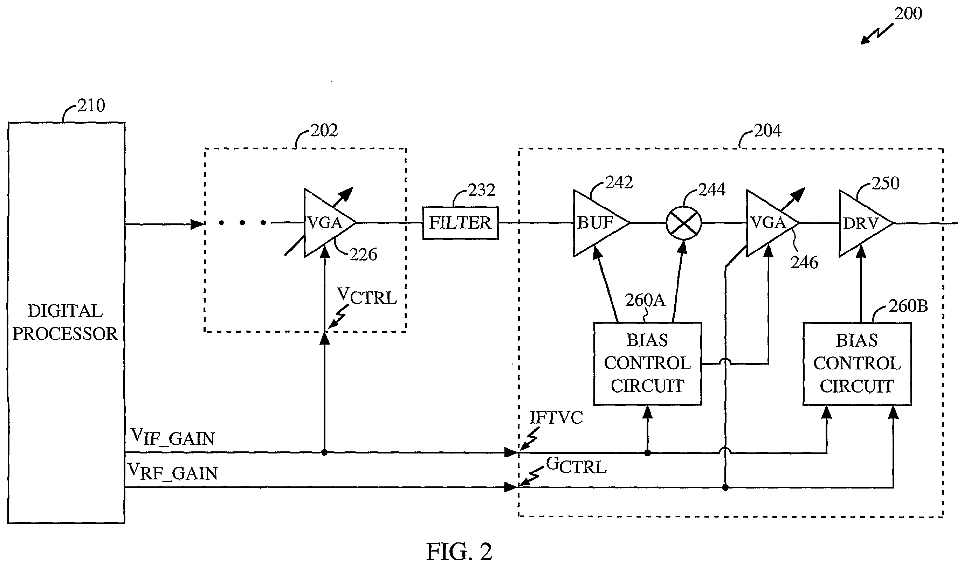

FIG. 2 shows a simplified block diagram of a specific implementation of a transmitter 200. The elements shown in FIG. 2 generally correspond to similarly labeled elements in FIG. 1. More specifically, digital processor 220, VGA 226, filter 232, buffer 242, mixer 244, VGA 246, PA driver 250, and bias control circuits 260a and 260b in FIG. 2 correspond to digital processor 120, IF VGA 126, filter 132, IF buffer 242, mixer 144, RF VGA 146, PA driver 150, and bias control circuits 160a and 160b in FIG. 1, respectively. As shown in FIG. 2, the IF signal path is implemented within a first integrated circuit (IC) 202, the RF signal path is implemented within a second IC 204, and filter 232 is implemented as a discrete filter (e.g., surface acoustic wave SAW filter).

As shown in FIG. 2, IC 202 includes an input pin (labeled as V_{CTRL}) that receives a gain control signal V_{IF_GAIN} used to adjust the gain of IF VGA 226. IC 204 includes an input pin (labeled as G_{CTRL}) that receives a gain control signal V_{RF_GAIN} used to adjust the gain of RF VGA 246. IC 204 further includes an input pin (labeled as IFTVC) that receives a gain control signal used to control bias control circuits 260a and 260b. In accordance with an aspect of the invention, the gain control signal V_{IF_GAIN} for the IF signal path is provided as a bias control signal for the RF signal path (i.e., provided to the IFTVC pin on IC 204).

Implementation of the transmit signal path using multiple ICs may be dictated by a number of design considerations such as, for example, the need to isolate the RF circuits for improved performance (e.g., noise consideration), compatibility with existing transmitter designs, lower cost, and others. The used of multiple ICs for the transmit signal path can complicate the design of an efficient and effective bias control mechanism for the reasons described below.

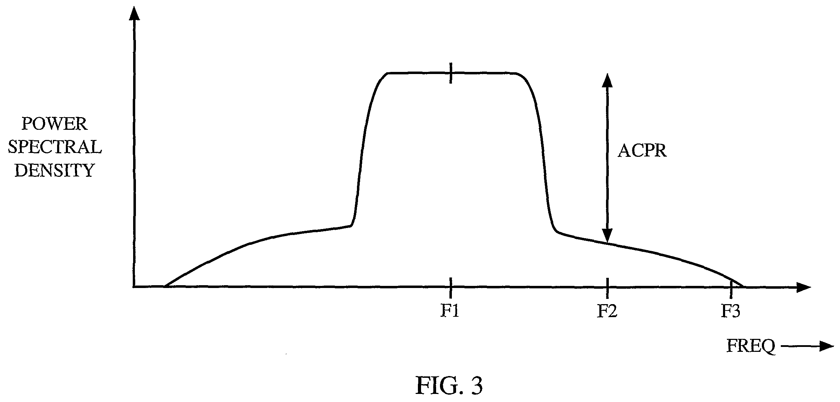

FIG. 3 shows a diagram of a CDMA spread spectrum signal and distortion components generated by non-linearity in the transmit signal path. The CDMA signal has a particular (e.g., 1.2288 MHz) bandwidth and a center frequency that is dependent on the operating mode (e.g., cellular or PCS). The distortion components are generated from the CDMA signal itself due to third and higher order non-linearity in the circuits in the transmit signal path. The distortion components, which are also referred to as spectral regrowth, cover the frequency band of the CDMA signal and the adjacent frequency bands. The distortion components act as interference on the CDMA signal and on the signals in the adjacent bands.

For third order non-linearity, signal components at frequencies of wₐ and w_{b} produce intermodulation products at frequencies of (2wₐ-w_{b}) and (2w_{b}-wₐ). Thus, in-band signal components can produce intermodulation products that can fall in-band or near band. These products can cause degradation in the CDMA signal itself and the signals in the adjacent bands. To compound the problem, the amplitude of the third-order intermodulation products is scaled by gₐ•g_{b}² and gₐ²•g_{b}, where gₐ and g_{b} are the gains of the signal components at wₐ and w_{b}, respectively. Thus, every doubling of the amplitude of the CDMA signal produces an eight-fold increase in the amplitude of the third order products.

For CDMA systems, the linearity of the remote station transmitter is specified by the adjacent channel power rejection (ACPR) specifications in the IS-95-A and IS-98 standards. The ACPR specifications typically apply to the entire transmit signal path, including the PA. The ACPR specifications are typically "apportioned" to different portions of the transmit signal path, each of which is then designed to meet the apportioned specifications. For example, the portion of the transmit signal path shown in FIG. 1 (up to and including PA driver 150) may be required to maintain the distortion components at -52 dBc per 30 KHz bandwidth at 885 KHz offset from the CDMA center frequency, and -64 dBc per 30 KHz bandwidth at 1.98 MHz offset.

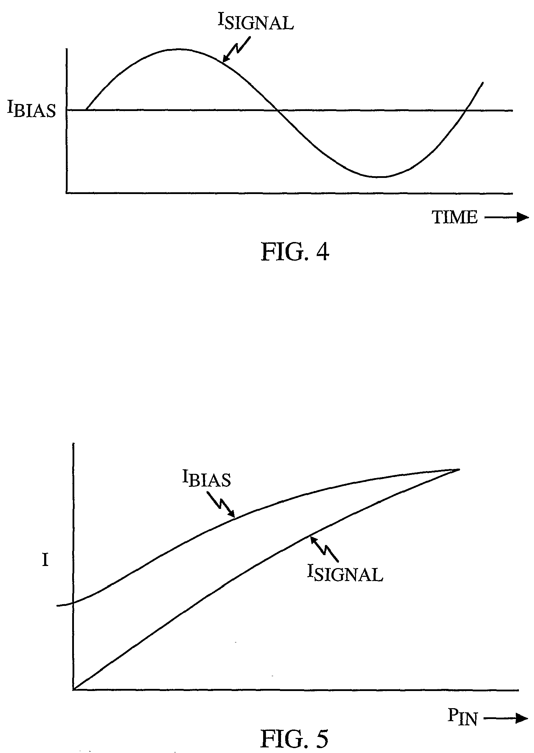

FIG. 4 shows a plot of the signal swing of a circuit in the transmit signal path for a particular bias current setting. As can be seen, the required bias current is dependent on the signal swing and should be set at least half the peak-to-peak signal swing for a class A amplifier. The linearity of the circuit typically degrades as the signal deviates further from the bias point, with the actual amount of non-linearity being dependent on the particular circuit design. Thus, the linearity of the output signal (e.g., the amount of spectral regrowth) is dependent on both the bias current and the signal swing

Generally, the amount of bias current required for a particular active circuit is dependent on the power (or signal) level of the input signal into the circuit. For a specific input power level Pᵢₙ, simulation can be performed or empirical measurements can be made to determine the minimum bias current for the circuit that will satisfy the ACPR specification and other performance criteria (e.g., noise figure and bandwidth). For example, for the transmitter embodiment shown in FIG. 1, the minimum bias currents that result in compliance with the IS-95-A ACPR specification can be individually determined for the buffers, mixers, VGAs, PA driver, and PA when the transmitter is transmitting at the maximum output power level. The simulation or measurement can then be repeated for these circuits at other power levels.

FIG. 5 shows plots of the bias current I_{bias} and the signal current I_{signal} for a particular active circuit (e.g., buffer 242, mixer 244, VGA 246, or PA driver 250 in FIG. 2) in the RF signal path versus input power level Pᵢₙ into the circuit. These plots can be generated from the data obtained above through simulation or empirical measurements. Generally, the signal current I_{signal} increases as the input power level Pᵢₙ increases, and decreases as the input power level decreases (approaching zero signal current at zero input power level). The relationship between the signal current and the input power level may not be linear, and is typically dependent on the particular circuit design, the technology used, the power supplies, temperature, and other factors.

As shown in FIG. 5, the bias current I_{bias} for the active circuit is typically set higher than the signal current I_{signal}, with the difference decreasing at higher input power levels and increasing at lower input power levels. At higher input power levels, a large amount of bias current is already used for the circuit and the amount of "over-bias" is reduced in order to conserve supply current. At lower input power levels, only a small amount of bias current is required by the circuit and the amount of over-bias is increased to ensure proper RF performance (e.g., bandwidth, noise performance) without expending an excessive amount of supply current.

FIG. 5 shows plots for one active circuit in the RF signal path. A similar set of plots can be generated for each active circuit in the RF signal path. The data from these plots is used to adjust the bias currents of the active circuits, as described below.

As noted above, the bias current for each active circuit in the RF signal path can be adjusted based on its input power level Pᵢₙ, or more specifically the power level at the input of the circuit. The input power level can be determined using various methods, some of which are described below.

In a specific transmitter design, a power detector is coupled to the transmit signal path, preferably after the variable gain element in the IF signal path. For example, the power detector can be placed after VGA 226 in FIG. 2 (i.e., at the output of IC 202) or after filter 232. The power detector detects the IF output power level and provides this information to the bias control circuit. The bias control circuit then adjusts the bias current of subsequent circuits in the RF signal path based on the detected power level. The use of a power detector and additional control circuitry increase system complexity and cost. The use of a power detector is also difficult in variable envelope modulation schemes (such as CDMA) in which the input power has short term variations that make it difficult to determine the input power instantaneously.

In accordance with an aspect of the invention, the IF output power level is estimated from the gain control signal(s) used to control the variable gain elements (e.g., VGA 226 in FIG. 2) in the IF signal path. For many transmitter designs, the gains of the VGAs are controlled in a manner to provide improved linearity and noise performance. Each transmitter output power level typically corresponds to a particular set of gain settings for the (IF and RF) VGAs that achieve these performance objectives.

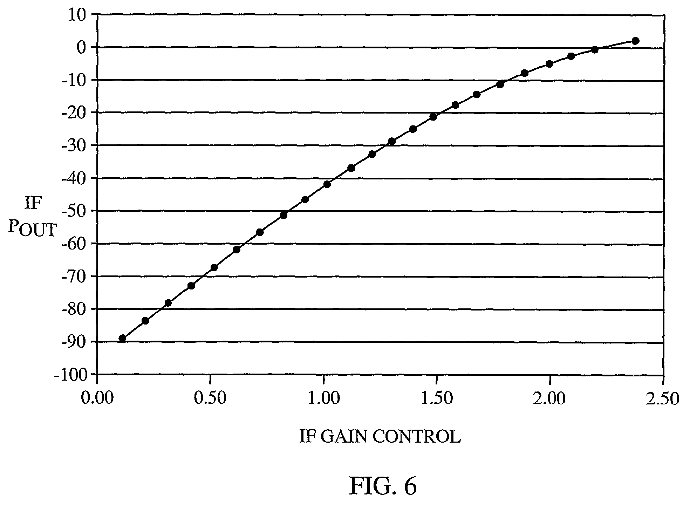

FIG. 6 shows a graph of the IF output power level (i.e., from IC 202 in FIG. 2) versus IF gain control for a specific transmitter design. For this graph, the gains of other circuits in the IF signal path are maintained at their normal gain settings. The graph in FIG. 6 can be obtained through circuit simulation or can be determined by empirical measurements (i.e., characterization) of many ICs. Each of the values plotted represents the maximum IF output power level under various specified operating conditions for a given IF gain control value. In accordance with good engineering practice and for a conservative circuit design, it is preferable to over estimate the IF output power level (which can result in consumption of more current than optimal) rather than to under estimate the output power level (which can result in performance degradation). As shown in FIG. 6, the IF output power level varies by approximately 90 dBm over an IF gain control voltage range of approximately 0.1 to 2.4 volts. The measured IF output power levels are later used to adjust the bias current of the circuits in the RF signal path.

In the specific implementation shown in FIG. 6, the entire gain range for the transmitter is provided by the IF VGA. In other transmitter implementations, the gain range can be divided between the IF and RF VGAs.

Because of the stringent power control setting mandated by the IS-95-A standard, the transmitter output power is sometimes calibrated at the factory. This calibration can be achieved by programming the gain control signals with known (i.e., digital) control values and measuring the output power from the transmitter. A table is then generated that maps each output power level to a set of (digital) control values. Thereafter, to set the transmit power at a particular power level, the table is accessed, the set of control values corresponding to the particular power level is retrieved, the retrieved control values are provided to the gain control circuit, the gain control signals are generated based on the control values, and the gains of the VGAs are adjusted with the gain control signals. For this transmitter implementation, the transmitter output power level and the input power levels at various locations along the transmit signal path can be accurately inferred from the gain control signals. However, even without the factory calibration, the input power levels can usually be estimated, to a sufficient degree of accuracy, from the gain control signals.

The power level at the input of IC 204 is related to the IF output power level from IC 202, minus the additional losses due to circuit elements coupled between these ICs. The additional losses are mainly due to the insertion loss of filter 232, but also include transmission line loss and other losses. The losses of these circuit elements are typically not known with a great deal of accuracy.

Referring to FIG. 2, filter 232 is typically implemented using a discrete filter. The insertion loss of the filter varies from one unit to another, and from one transmitter design to another. Consequently, some uncertainty exists as to the actual amplitude of the signal from the filter. As described above, in some transmitter implementations, the transmit signal path is characterized by empirical measurements performed at the factory, and the insertion loss of the filter is taken into account. However, even when no calibration is performed, the variation in the filter insertion loss is typically small and can be neglected. To provided additional safety margins, the bias currents of the circuits in the transmit signal path following the filter can be set slightly higher to account for the uncertainty in insertion loss.

In an embodiment, for a worse case (i.e., conservative) design, the additional losses due to circuit elements between ICs 202 and 204 are presumed to be 0 dB (i.e., no loss), which may result in a larger estimated input power level at the input of the RF signal path. This 0 dB loss assumption will likely have minor impact since the additional losses (e.g., typically several dBs) are small relative to the large range of the input power levels (e.g., 90 dB) for the RF signal path.

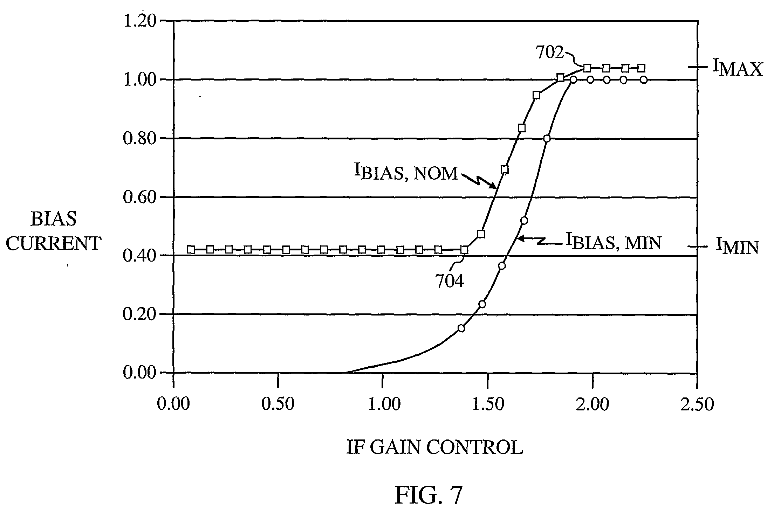

FIG. 7 shows a plot of the minimum bias current I_{bias,min} for a particular active circuit (e.g., buffer 242, mixer 244) in the RF signal path versus the IF gain control for a specific transmitter design. This plot can be generated from the plot of the bias current I_{bias} versus input power level Pᵢₙ of the RF signal path (see FIG. 5) and the plot of the IF output power level (IF Pₒᵤₜ) versus IF gain control (see FIG. 6). Again, the Pᵢₙ of the RF signal path is estimated to be equal to the Pₒᵤₜ of the IF signal path (i.e., Pₒᵤₜ ≅ Pᵢₙ). In FIG. 7, the minimum bias current I_{bias,min} is normalized such that the maximum bias amount is set to 1.0, which is also referred to as the full-scale value. At low Pᵢₙ power levels, the required bias current approaches zero.

For many transmitter designs, it is impractical to operate the circuit at the minimum bias current I_{bias,min}. This may be due to a number of factors, such as variations in circuit performance (e.g., bandwidth and gain) over operation conditions (e.g., time, temperature, and supply voltages). Moreover, circuit performance typically varies from IC to IC due to component tolerance. Thus, to account for these factors, the actual or nominal bias current for the circuit is set higher than the minimum bias current.

FIG. 7 also shows a plot of the nominal bias current I_{bias,nom} for the circuit versus IF gain control. As shown in FIG. 7, the nominal bias current I_{bias,nom} is set higher than the minimum bias current I_{bias,min}. The additional bias current, which is also referred to as the over-bias current, accounts for various factors such as error in the estimate of the actual input power level into the circuit, and so on. The additional bias current ensures that the circuit is sufficiently biased for correct operation and to provide the required level of linearity over operating conditions and component variations. The amount of over-bias can be selected such that performance is maintained without excessively sacrificing potential current savings. In an embodiment, the amount of over-bias is dependent on the input power level (which is related to the IF gain control). Specifically, the amount of over-bias being smaller (i.e., percentage wise) at greater bias current levels.

In the embodiment shown in FIG. 7, the nominal bias current I_{bias,nom} reaches an asymptotic upper value Iₘₐₓ above a point 702 and an asymptotic lower value Iₘᵢₙ below a point 704. In a specific embodiment, Iₘₐₓ is set approximately five percent higher than the full-scale value or a normalized value of approximately 1.05. The amount of over-bias is selected to be small at high input power levels because high bias current is already provided to the circuit. In a specific embodiment, Iₘᵢₙ is set at a particular percentage (e.g., 10 to 50 percent) of either the full-scale or Iₘₐₓ value. The bias current typically affects the frequency response and the bandwidth as well as the linearity of the circuit. Thus, limiting the bias current to Iₘᵢₙ or greater ensures that the circuit has the required performance (e.g., the required signal bandwidth) at all times.

The plot of the nominal bias current in FIG. 7 resembles a hyperbolic function between a maximum value Iₘₐₓ and a minimum value Iₘᵢₙ. In an embodiment, Iₘₐₓ and Iₘᵢₙ are programmable current values.

Referring back to FIG. 2, in accordance with an aspect of the invention, the bias currents of some of the circuit elements (e.g., buffer 242, mixer 244, and VGA 246) in the RF signal path are determined based on the IF gain control signal, which is indicative of the input power level into the RF signal path, as described above.

The bias currents of some other circuit elements (e.g., PA driver 250) in the RF signal path can be determined based on the IF and RF gain control signals. The RF gain control signal determines the gain of RF VGA 246, which affects the power level within the RF VGA and the input power level of subsequent circuits. The gain of RF VGA 246 versus RF gain control can be simulated or empirically determined in a similar manner as for the IF VGA. The gains of preceding circuit elements (e.g., buffer 242 and mixer 244) can also be determined. Thereafter, for a particular set of IF and RF gain control values, the power level from the RF VGA can be estimated from (1) the input power level Pᵢₙ into IC 204, which is estimated from the IF gain control, (2) the gains of buffer 242 and mixer 244, which are typically fixed values, and (3) the gain of the RF VGA, which is determined from the RF gain control value.

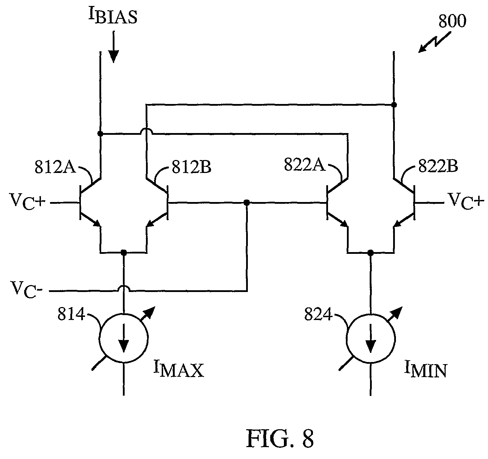

FIG. 8 shows a schematic diagram of an embodiment of a bias control circuit 800 used to generate a bias current I_{bias} having a transfer function resembling the hyperbolic function shown in FIG. 7. The bias current generated by bias control circuit 800 can be used for one circuit in the RF signal path, such as IF buffer 242, mixer 244, RF VGA 246, or PA driver 250 in FIG. 2.

Within bias circuit 800, a first differential pair comprising transistors 812a and 812b receives the differential gain control signals V_{c}+ and V_{c}-, respectively. The differential control signals V_{c}- and V_{c}+ can correspond to either the IF or RF gain control signal. The emitters of the first differential pair couple to a current source 814 that sets the maximum bias current Iₘₐₓ. A second differential pair comprising transistors 822a and 822b receives the differential gain control signals V_{c}- and V_{c}+, respectively. The emitters of the second differential pair couple to a current source 824 that sets the minimum bias current Iₘᵢₙ. The collectors of transistors 812a and 822a couple together to form the signal path for the bias current Iₘᵢₙ. Similarly, the collectors of transistors 812b and 822b couple together to form the signal path for the complementary bias current.

As shown in FIG. 8, current sources 814 and 824 can each be designed to be adjustable or programmable to allow for adjustment of Iₘₐₓ and Iₘᵢₙ. In a specific embodiment, each programmable current source is implemented with a bank of transistors that are selectively enabled based on a set of digital control values. The amount of current provided by the current source increases as more transistors in the bank are enabled. The current in the current source can be accurately set by using a current mirror, with the reference current in the current mirror being set by a bandgap reference circuit and an accurate (e.g., discrete, external) resistor. The use of the bandgap reference circuit and current mirror in this manner is known in the art and not described in detail herein.

In a specific embodiment, each programmable current source is controlled by a digital-to-analog circuit (DAC). The DAC provides a control signal based on a set of digital control values. The control signal then determines the amount of current provided by the current source.

For a particular active circuit (e.g., PA driver 250 in FIG. 2) in the transmit signal path having a bias current that may be dependent on two or more gain control signals, the bias control circuit shown in FIG. 8 can be replicated for each control signal. The I_{bias} signal paths for all bias control circuits are coupled together, and the complementary I_{bias} signal paths of all bias control circuits are also coupled together. The Iₘₐₓ and Iₘᵢₙ currents corresponding to each gain control signal can be set based, for example, on the input power versus gain control transfer function determined above for the gain control signal.

FIG. 8 indicates that the bias current can be continuously adjusted in accordance with the gain control signal. In some transmitter embodiments in which one or more VGAs are adjusted in coarse increments, the bias currents of the circuits in the transmit signal path (including the PA driver) can be adjusted based on the coarse gain setting. At high input power levels, which generally correspond to high VGA gains, more bias current is needed for the larger signal swing. The transmitter recognizes the need for more bias current when the VGA gain is set to a high gain setting, and uses this information to increase the bias current of the circuit. This design conserves (battery) power by reducing bias current in the circuit when the input power level is low.

Referring back to FIG. 2, the gain of IF VGA 226 affects the power level at the inputs of subsequent circuits (after VGA 226) in the transmit signal path, including IF buffer 242, mixer 244, RF VGA 246, and PA driver 250. Thus, the bias currents of these circuits can be adjusted in accordance with the IF gain control signal that sets the gain of IF VGA 226. Similarly, the gains of VGAs 226 and 246 affect the power level at the inputs of subsequent circuits (after VGA 246) in the transmit signal path, including VGA 246 and PA driver 250. Thus, the bias current of these circuits can be adjusted in accordance with IF and RF gain control signals. Generally, the bias current of any particular active circuit in the transmit signal path can be adjusted based on the gain control signal(s) of the variable gain elements preceding that circuit. This can be achieved since the bias control and gain control variations tend to track. One or more variable gain elements can be neglected in setting the bias current. For example, the bias current of PA driver 250 can be adjusted based solely on the gain of VGA 246, or solely on the gain of VGA 226, or the combined gain of both VGAs 226 and 246.

The bias control mechanism of the invention can also be used to adjust the bias currents of peripheral circuits in the transmitter, such as the buffers for the local oscillators (e.g., the buffers used to provide the IF LO and the RF LO in FIG. 1). The bias current of a particular peripheral circuit can be adjusted based on the amplitude of the signal on which the circuit is designed to operate (albeit indirectly). The power level amplitude can be estimated from the gain control signal provided to the variable gain element(s) located "upstream" in the signal path. For example, the bias current of the buffer for the RF LO can be made dependent on the IF gain control signal.

Table 1 tabulates the total bias current of the circuits in the RF signal path for a specific transmitter embodiment. Other transmitter embodiments are also possible and are within the scope of the invention. For this specific embodiment, in the sleep mode, the transmitter is turned off by shutting off the bias current to most circuits in the transmit signal path. In the idle mode, the circuits are bias in preparation for operation, but no transmissions occur. The cellular and PCS modes operate on two frequency bands, and may be characterized by the use of different LO frequencies and different PAs.

**Table 1**

| Mode | Input Power into RF Signal Path | RF VGA Gain | Total Bias Current of RF Signal Path |
|---|---|---|---|
| Sleep | x | x | <1µA |
| Idle | x | x | 6 mA |
| Cellular | Low | Low | 35 mA |
| | Low | High | 41 mA |
| | High | Low | 78 mA |
| | High | High | 91 mA |
| PCS | Low | Low | 34 mA |
| | Low | High | 42 mA |
| | High | Low | 74 mA |
| | High | High | 92 mA |

In FIGS. 1 and 2, the (analog) gain control signals provided to the VGAs are also provided to the bias control circuits. In some transmitter embodiments, each gain control signal is generated by a DAC based on an input digital control value. The transmitter can also be designed such that the bias control circuits receive the digital control values, instead of the (analog) gain control signals, from the gain control circuit.

As shown in FIG. 2, bias control circuits 260a and 260b are implemented within IC 204 that implements the RF signal path. However, these circuits can also be implemented within a separate IC, or integrated within other circuits such as digital processor 210.

The foregoing description of the preferred embodiments is provided to enable any person skilled in the art to make or use the present invention. Various modifications to these embodiments will be readily apparent to those skilled in the art, and the generic principles defined herein may be applied to other embodiments without the use of the inventive faculty. Thus, the present invention is not intended to be limited to the embodiments shown herein but is to be accorded the widest scope consistent with the principles and novel features disclosed herein.

## Claims

1. A method of controlling a bias current of an active circuit in a transmit signal path comprising:
receiving at least one gain control signal (128), each gain control signal indicative of a signal gain of a variable gain element (126, 226) located prior to the active circuit (142, 144, 150, 242, 244, 250) in the transmit signal path;
estimating a signal level of an input signal provided to the active circuit, wherein the estimated input signal level is based, in part, on the received at least one gain control signal (128);
determining a bias current for the active circuit based, in part, on the estimated input signal level;
limiting the determined bias current to within a range defined by an upper bias current and a lower bias current; and
biasing the active circuit with the limited bias current.

2. The method of claim 1, wherein the input signal is provided from a first integrated circuit (202) and the active circuit is implemented on a second integrated circuit (204).

3. The method of claim 1, wherein the transmit signal path includes one variable gain element (126, 226) having a variable gain determined by an IF gain control signal (128).

4. The method of claim 1, wherein the transmit signal path includes an IF portion coupled to a RF portion, and wherein the signal gain (128) relates to the IF portion and the active circuit is implemented within the RF portion.

5. The method of claim 4, further comprising:
characterizing an output signal level of the IF portion versus the at least one gain control signal (128).

6. The method of claim 5, wherein the input signal level is estimated as equal to the characterized output signal level from the IF portion.

7. The method of claim 1, wherein the lower bias current is set at between 10 to 50 percents of the upper bias current.

8. The method of claim 1, wherein the determined bias current approximately tracks the variation of the input signal level versus the received at least one gain control signal.

9. The method of claim 1, wherein the determined bias current versus the received at least one gain control signal approximately conforms to a hyperbolic transfer function.

10. The method of claim 1, wherein the determined bias current is selected to achieve a level of linearity that conforms to an adjacent channel power rejection ACPR specification defined by IS-95-A standard.

11. The method of claim 1, wherein the determined bias current is compensated for temperature and power supply variations.

12. The method of claim 1, wherein the bias current is determined based on gain control signals (128, 148) for all variable gain elements (126, 226) located in the transmit signal path prior to the active circuit.

13. The method of claim 1, wherein the active circuit is a mixer (144, 244).

14. The method of claim 1, wherein the active circuit is a buffer (142, 242) or amplifier.

15. A transmitter (100, 200) comprising:
at least one variable gain element (126, 226) implemented on a first integrated circuit (202);
at least one active circuit implemented on a second integrated circuit (204), wherein an output of the first integrated circuit operatively couples to an input of the second integrated circuit;
a gain control circuit (130) coupled to the at least one variable gain element (126, 226, 146, 246), the gain control circuit configured to provide a gain control signal (128, 148) for each variable gain element; and
at least one bias control circuit (160A, 160B, 260A, 260B, 800) coupled to the gain control circuit and to selected ones of the at least one active circuit, the bias control circuit configured to receive at least one gain control signal (128, 148) and to provide a bias signal for each selected active circuit, wherein the bias signal for a particular active circuit is generated in accordance with one or more gain control signals for one or more variable gain elements located prior to the particular active circuit in the transmit signal path wherein each bias control circuit includes:
a pair of current sources (814, 824), one current source configured to provide a first bias current and the other current source configured to provide a second bias current, wherein the bias signal provided by the bias control circuit is limited to a value between the first and second bias currents, and
a pair of differential pairs (812a, 812b, 822a, 822b), one differential pair coupled to each current source.

16. The transmitter of claim 15, wherein each variable gain element (126, 146, 226, 246) is implemented with a variable gain amplifier (VGA), an attenuator, or a multiplier.

17. The transmitter of claim 15, wherein the at least one active circuit includes a mixer (144, 244).

18. The transmitter of claim 15, wherein the at least one active circuit includes a buffer (142, 242) or an amplifier.

19. The transmitter of claim 15, wherein the current sources are programmable.

20. The transmitter of claim 15, further comprising:
a bandgap reference source coupled to the at least one bias control circuit.

## Patentansprüche

1. Ein Verfahren zum Steuern eines Vorspannungsstroms einer aktiven Schaltung in einem Sende- bzw. Übertragungssignalpfad, das Folgendes aufweist:
Empfangen wenigstens eines Verstärkungssteuerungssignals (128), wobei jedes Verstärkungssteuerungssignal eine Signalverstärkung eines Elements (126, 226) mit variabler Verstärkung anzeigt, das vor der aktiven Schaltung (142, 144, 150, 242, 244, 250) in dem Übertragungssignalpfad angeordnet ist;
Schätzen eines Signalpegels eines Eingangssignals, das an die aktive Schaltung geliefert wird, wobei der geschätzte Eingangssignalpegel teilweise auf dem empfangenen, wenigstens einen Verstärkungssteuerungssignal (128) basiert;
Bestimmen eines Vorspannungsstroms für die aktive Schaltung basierend teilweise auf dem geschätzten Eingangssignalpegel;
Begrenzen des bestimmten Vorspannungsstroms auf innerhalb eines Bereichs, der durch einen oberen Vorspannungsstrom und einen unteren Vorspannungsstrom definiert wird; und
Vorspannen der aktiven Schaltung mit dem begrenzten Vorspannungsstrom.

2. Verfahren nach Anspruch 1, wobei das Eingangssignal von einer ersten integrierten Schaltung (202) vorgesehen wird und die aktive Schaltung auf einer zweiten integrierten Schaltung (204) implementiert wird.

3. Verfahren nach Anspruch 1, wobei der Übertragungssignalpfad ein Element (126, 226) mit variabler Verstärkung beinhaltet, das eine variable Verstärkung hat, die durch ein IF-Verstärkungssteuerungssignal (128) bestimmt wird.

4. Verfahren nach Anspruch 1, wobei der Übertragungssignalpfad einen IF-Abschnitt beinhaltet, der an den RF-Abschnitt gekoppelt ist, und wobei die Signalverstärkung (128) mit dem IF-Abschnitt in Beziehung steht und die aktive Schaltung innerhalb des RF-Abschnittes implementiert ist.

5. Verfahren nach Anspruch 4, das weiter Folgendes aufweist:
Charakterisieren eines Ausgangssignalpegels des IF-Abschnitts gegenüber dem wenigstens einen Verstärkungssteuerungssignal (128).

6. Verfahren nach Anspruch 5, wobei der Eingangssignalpegel so geschätzt wird, dass er gleich dem charakterisierten Ausgangssignalpegel von dem IF-Abschnitt ist.

7. Verfahren nach Anspruch 1, wobei der untere Vorspannungsstrom auf zwischen 10 bis 50 Prozent des oberen Vorspannungsstroms eingestellt ist.

8. Verfahren nach Anspruch 1, wobei der bestimmte Vorspannungsstrom ungefähr die Variation des Eingangssignalpegels gegenüber dem empfangenen wenigstens einen Verstärkungssteuerungssignal nachführt.

9. Verfahren nach Anspruch 1, wobei der bestimmte Vorspannungsstrom gegenüber dem empfangenen wenigstens einen Verstärkungssteuerungssignal ungefähr einer hyperbolischen Transferfunktion entspricht.

10. Verfahren nach Anspruch 1, wobei der bestimmte Vorspannungsstrom ausgewählt ist, um einen Niveau an Linearität zu erreichen, das einer ACPR-Spezifikation (ACPR = adjacent channel power rejection bzw. Nachbarkanalleistungsunterdrückung) entspricht bzw. zu dieser konform ist, die durch den IS-95-A-Standard definiert wird.

11. Verfahren nach Anspruch 1, wobei der bestimmte Vorspannungsstrom für Temperatur- und Leistungsversorgungsvariationen kompensiert ist.

12. Verfahren nach Anspruch 1, wobei der Vorspannungsstrom basierend auf Verstärkungssteuerungssignalen (128, 148) für alle Elemente (126, 226) mit variabler Verstärkung bestimmt wird, die in dem Übertragungssignalpfad vor der aktiven Schaltung angeordnet sind.

13. Verfahren nach Anspruch 1, wobei die aktive Schaltung ein Mischelement bzw. ein Mischer (144, 244) ist.

14. Verfahren nach Anspruch 1, wobei die aktive Schaltung ein Puffer (142, 242) oder ein Verstärker ist.

15. Ein Sender (100, 200), der Folgendes aufweist:
wenigstens ein Element (126, 226) mit variabler Verstärkung, das auf einem ersten integrierten Schaltkreis (202) implementiert ist;
wenigstens eine aktive Schaltung, die auf einem zweiten integrierten Schaltkreis (204) implementiert ist, wobei ein Ausgang der ersten integrierten Schaltung betriebsmäßig an einen Eingang der zweiten integrierten Schaltung gekoppelt ist;
eine Verstärkungssteuerungsschaltung (130), die an das wenigstens eine Element (126, 226, 146, 246) mit variabler Verstärkung gekoppelt ist, wobei die Verstärkungssteuerungsschaltung konfiguriert ist, um ein Verstärkungssteuerungssignal (128, 148) für jedes Element mit variabler Verstärkung vorzusehen; und
wenigstens eine Vorspannungssteuerungsschaltung (160A, 160B, 260A, 260B, 800), die an die Verstärkungssteuerungsschaltung und an ausgewählte der wenigstens einen aktiven Schaltung gekoppelt ist, wobei die Vorspannungssteuerungsschaltung konfiguriert ist zum Empfangen wenigstens eines Verstärkungssteuerungssignals (128, 148) und zum Liefern eines Vorspannungssignals für jede ausgewählte, aktive Schaltung, wobei das Vorspannungssignal für eine bestimmte aktive Schaltung gemäß einem oder mehreren Verstärkungssteuerungssignalen für ein oder mehrere Elemente mit variabler Verstärkung erzeugt wird, die vor der bestimmten aktiven Schaltung in dem Sende- bzw. Übertragungssignalpfad angeordnet sind, wobei jede Vorspannungssteuerungsschaltung Folgendes beinhaltet:
ein Paar von Stromquellen (814, 824), wobei eine Stromquelle konfiguriert ist, um einen ersten Vorspannungsstrom zu liefern und die andere Stromquelle konfiguriert ist, um einen zweiten Vorspannungsstrom zu liefern,
wobei das Vorspannungssignal, das von der Vorspannungssteuerungsschaltung geliefert wird, auf einen Wert zwischen den ersten und zweiten Vorspannungsströmen begrenzt ist, und
ein Paar von differenziellen Paaren (812a, 812b, 822a, 822b), wobei ein differenzielles Paar an jede Stromquelle gekoppelt ist.

16. Sender nach Anspruch 15, wobei jedes Element (126, 146, 226, 246) mit variabler Verstärkung mit einem Verstärker mit variabler Verstärkung bzw. VGA (VGA = variable gain amplifier), einem Dämpfungselement oder einem Multiplikationselement implementiert ist.

17. Sender nach Anspruch 15, wobei die wenigstens eine aktive Schaltung ein Mischelement (144, 244) beinhaltet.

18. Sender nach Anspruch 15, wobei die wenigstens eine aktive Schaltung einen Puffer (142, 242) oder einen Verstärker beinhaltet.

19. Sender nach Anspruch 15, wobei die Stromquellen programmierbar sind.

20. Sender nach Anspruch 15, der weiter Folgendes aufweist:
eine Bandlückenreferenzquelle, die an die wenigstens eine Vorspannungssteuerschaltung gekoppelt ist.

## Revendications

1. Procédé de commande d'un courant de polarisation d'un circuit actif sur un trajet d'un signal d'émission comprenant :
la réception d'au moins un signal de commande de gain (128), chaque signal de commande de gain étant indicatif d'un gain de signal d'un élément à gain variable (126, 226) situé en amont du circuit actif (142, 144, 150, 242, 244, 250) sur le trajet du signal d'émission ;
l'estimation d'un niveau de signal d'un signal d'entrée fourni au circuit actif, dans lequel le niveau estimé du signal d'entrée est basé, en partie, sur l'au moins un signal de commande de gain reçu (128) ;
la détermination d'un courant de polarisation pour le circuit actif sur la base, en partie, du niveau du signal d'entrée estimé ;
la limitation du courant de polarisation déterminé à une plage définie par un courant de polarisation supérieure et un courant de polarisation inférieure ; et
la polarisation du circuit actif au moyen du courant de polarisation ainsi limité.

2. Procédé selon la revendication 1, dans lequel le signal d'entrée est fourni à partir d'un premier circuit intégré (202) et le circuit actif est réalisé sur un deuxième circuit intégré (204).

3. Procédé selon la revendication 1, dans lequel le trajet du signal d'émission comprend un élément à gain variable (126, 226) ayant un gain variable déterminé par un signal de commande de gain de fréquence intermédiaire FI (128).

4. Procédé selon la revendication 1, dans lequel le trajet du signal d'émission comprend une partie FI couplée à une partie RF, et dans lequel le gain du signal (128) se rapporte à la partie FI et le circuit actif est réalisé au sein de la partie RF.

5. Procédé selon la revendication 4, comprenant en outre :
la caractérisation d'un niveau de signal de sortie de la partie FI par rapport à l'au moins un signal de commande de gain (128).

6. Procédé selon la revendication 5, dans lequel le niveau de signal d'entrée est estimé comme étant égal au niveau du signal de sortie caractérisé à partir de la partie FI.

7. Procédé selon la revendication 1, dans lequel le courant de polarisation inférieur est réglé pour correspondre à entre 10 et 50 pourcent du courant de polarisation supérieur.

8. Procédé selon la revendication 1, dans lequel le courant de polarisation déterminé suit approximativement la variation du niveau du signal d'entrée par rapport à l'au moins un signal de commande de gain reçu.

9. Procédé selon la revendication 1, dans lequel le courant de polarisation déterminé par rapport à l'au moins un signal de commande de gain reçu se conforme approximativement à une fonction de transfert hyperbolique.

10. Procédé selon la revendication 1, dans lequel le courant de polarisation déterminé est choisi pour atteindre un niveau de linéarité qui est conforme à une spécification de réjection de puissance de canal adjacent ACPR définie par la norme IS-95-A.

11. Procédé selon la revendication 1, dans lequel le courant de polarisation déterminé est compensé en ce qui concerne des variations de température et d'alimentation.

12. Procédé selon la revendication 1, dans lequel le courant de polarisation est déterminé sur la base de signaux de commande de gain (128, 148) pour tous les éléments à gain variable (126, 226) situés sur le trajet du signal d'émission en amont du circuit actif.

13. Procédé selon la revendication 1, dans lequel le circuit actif est un mélangeur (144, 244).

14. Procédé selon la revendication 1, dans lequel le circuit actif est un circuit tampon (142, 242) ou un amplificateur.

15. Un émetteur (100, 200) comprenant:
au moins un élément à gain variable (126, 226) réalisé sur un premier circuit intégré (202) ;
au moins un circuit actif réalisé sur un deuxième circuit intégré (204), dans lequel une sortie du premier circuit intégré est couplée fonctionnellement à une entrée du deuxième circuit intégré ;
un circuit de commande de gain (130) couplé à l'au moins un élément à gain variable (126, 226, 146, 246), le circuit de commande de gain étant configuré pour fournir un signal de commande de gain (128, 148) pour chaque élément à gain variable ; et
au moins un circuit de commande de polarisation (160A, 160B, 260A, 260B, 800) couplé au circuit de commande de gain et au(x) circuit(s) sélectionné(s) parmi l'au moins un circuit actif, le circuit de commande de polarisation étant configuré pour recevoir au moins un signal de commande de gain (128, 148) et pour fournir un signal de polarisation pour chaque circuit actif sélectionné, dans lequel le signal de polarisation pour un circuit actif particulier est généré conformément à un ou plusieurs signaux de commande de gain pour un ou plusieurs éléments à gain variable situés en amont du circuit actif particulier sur le trajet du signal d'émission, dans lequel chaque circuit de commande de polarisation comprend :
une paire de sources de courant (814, 824), une source de courant étant configurée pour fournir un premier courant de polarisation et l'autre source de courant étant configurée pour fournir un deuxième courant de polarisation, dans lequel le signal de polarisation fourni par le circuit de commande de polarisation est limité à une valeur comprise entre le premier est le deuxième courant de polarisation, et
une paire de paires différentielles (812a, 812b, 822a, 822b) une paire différentielle étant couplée à chaque source de courant.

16. Emetteur selon la revendication 15, dans lequel chaque élément à gain variable (126, 146, 226, 246) est réalisé avec un amplificateur à gain variable (AGV), un atténuateur ou un multiplicateur.

17. Emetteur selon la revendication 15, dans lequel le au moins un circuit actif comprend un mélangeur (144, 244).

18. Emetteur selon la revendication 15, dans lequel le au moins un circuit actif comprend un circuit tampon (142, 242) ou un amplificateur.

19. Emetteur selon la revendication 15, dans lequel les sources de courant sont programmables.

20. Emetteur selon la revendication 15, comprenant en outre :
une source de référence de bande interdite couplée à l'au moins un circuit de commande de polarisation.
